# EUROPÄISCHE PATENTSCHRIFT

(11) **EP 4 419 929 B1**
(45) Veröffentlichungstag und Bekanntmachung des Hinweises auf die Patenterteilung: **13.05.2026**
(21) Anmeldenummer: 22822088.5
(22) Anmeldetag: 24.11.2022
(51) Int. Cl.: G01R 31/327, G01K 7/34

(54) **ELEKTRISCHES SCHALTGERÄT FÜR HOCHSPANNUNG MIT INTEGRIERTEM FEHLER-DETEKTOR, VERFAHREN ZUM DETEKTIEREN EINES FEHLERS DES SCHALTGERÄTS FÜR HOCHSPANNUNG UND VERWENDUNG DES SCHALTGERÄTES FÜR HOCHSPANNUNG**
ELECTRICAL SWITCHING DEVICE FOR HIGH VOLTAGE WITH INTEGRATED FAULT DETECTOR, METHOD FOR DETECTING A FAULT IN THE HIGH VOLTAGE SWITCHING DEVICE AND USE OF THE HIGH VOLTAGE SWITCHING DEVICE
APPAREIL DE COMMUTATION ÉLECTRIQUE HAUTE TENSION POURVU DE DÉTECTEUR DE DÉFAUT INTÉGRÉ, PROCÉDÉ DE DÉTECTION D'UN DÉFAUT DE L'APPAREIL DE COMMUTATION HAUTE TENSION ET UTILISATION DE L'APPAREIL DE COMMUTATION HAUTE TENSION

(30) Priorität: 10.12.2021 EP 21213633
(43) Veröffentlichungstag der Anmeldung: 28.08.2024
(73) Patentinhaber: Siemens Aktiengesellschaft, 80333 München (DE)
(72) Erfinder: AUMANN, Erhard, 67550 Worms (DE); MLADENOVIC, Ivana, 90556 Seukendorf (DE)
(74) Vertreter: Siemens Patent Attorneys
(86) Internationale Anmeldenummer: PCT/EP2022/083199
(87) Internationale Veröffentlichungsnummer: WO 2023/104537

(56) Entgegenhaltungen:
- WO-A1-96/10263
- DE-A1- 102008 063 682
- DE-A1- 102014 102 509

## Beschreibung

Die Erfindung betrifft ein elektrisches Schaltgerät für Hochspannung mit integriertem Fehler-Detektor. Daneben werden ein Verfahren zum Detektieren eines Fehlers des elektrischen Schaltgeräts für Hochspannung und eine Verwendung des elektrischen Schaltgeräts für Hochspannung angegeben.

Das elektrische Schaltgerät für Hochspannung ist ein Schalter zum Schalten eines elektrischen Stroms mit einer Wechselspannung von über 1 kV. Eine der häufigen Fehlerquellen in einer Schaltanlage mit einem solchen Schaltgerät stellen die in der Schaltanlage befindlichen hochspannungsführenden Komponenten des Schaltgeräts in Form von Verschraubungen (Schraubverbindungen) dar. Insbesondere mit einer Schraubverbindung, die erst an einem Zielort der Schaltanlage montiert wird, ist ein relativ hohes Ausfallrisiko verbunden.

Dabei spielt eine Schraubverbindung des elektrischen Schaltgeräts, mit deren Hilfe eine Sammelschiene mit einem Hochspannungskabel verbunden wird, eine wichtige Rolle. Eine solche Schraubverbindung kann sich im Laufe des Betriebes verschlechtern, insbesondere bei unsachgemäßer Montage, wodurch eine zusätzliche lokale Erwärmung an der Schraubverbindung entsteht, die zu einem Abweichen von einer normalen Betriebstemperatur des Schaltgeräts und damit schließlich zu einem Ausfall des Schaltgeräts führen kann.

Für eine Abschätzung des Ausfallrisikos des -elektrischen Schaltgeräts mit der Schraubverbindung aufgrund der Erwärmung der Schraubverbindung ist eine Messung einer Temperatur an der Schraubverbindung wichtig. Dafür wird ein Temperatur-Sensor benötigt. Der Temperatur-Sensor fungiert als Fehler-Detektor, mit dem eine Auffälligkeit im Hinblick auf die Temperatur an der Schraubverbindung erfasst werden kann.

Aus der DE 10 2014 102509 A1 ist ein Verfahren zum Ermitteln einer Temperatur im Bereich eines Hochspannungsleiters eines solchen Schaltgeräts mit Hilfe eines Temperatursensors bekannt. Mit Hilfe der ermittelten (gemessenen) Temperatur wird auf die Temperatur des Hochspannungsleiters geschlossen.

Die Messung der Temperatur an der Schraubverbindung ist aber schwierig, da für eine vorteilhafte Positionierung eines geeigneten Temperatur-Sensors (z.B. SAW (Surface Acoustic Wafe)-Sensor oder PT1000 (Widerstandsthermometer)) in der Nähe der Schraubverbindung das elektrische Schaltgerät nur schlecht nachgerüstet werden kann.

Aufgabe der vorliegenden Erfindung ist es aufzuzeigen, wie ein elektrische Schaltgerät für Hochspannung mit einem Fehler-Detektor ausgestattet werden kann, ohne dass ein separates Bauteil für einen Fehler-Detektor angebracht werden muss.

Zur Lösung der Aufgabe wird ein elektrisches Schaltgerät für Hochspannung mit mindestens einer Feld-Steuer-Elektrode zur Feld-Steuerung mindestens einer hochspannungs-führenden Komponente des elektrischen Schaltgeräts und mit mindestens einen im elektrischen Schaltgerät integrierten Fehler-Detektor zum Detektieren eines Fehlers des elektrischen Schaltgeräts angegeben. Dabei weist der Fehler-Detektor die Feld-Steuer-Elektrode auf. Zudem weist der Fehler-Detektor einen Temperatur-Sensor zum Erfassen einer Temperatur des elektrischen Schaltgeräts auf. Für den Temperatur-Sensor weist die Feld-Steuer-Elektrode mindestens eine Kapazitäts-Elektrode einer Hochspannungs-Kapazität des elektrischen Schaltgeräts auf. Die Hochspannungs-Komponente weist ein mit der Feld-Steuer-Elektrode elektrisch gekoppeltes Kapazitäts-Dielektrikum auf. Das Kapazitäts-Dielektrikum weist mindestens einen eine Temperaturabhängigkeit aufweisenden dielektrischen Parameter auf.

Der Fehler des Schaltgeräts stellt eine Abweichung einer Ist-Temperatur des Schaltgeräts von einer Soll-Temperatur des Schaltgeräts bzw. von einem Bereich der Soll-Temperatur des Schaltgeräts dar. Der Fehler-Detektor ist eine ÜberwachungsEinheit zum Überwachen der Temperatur des elektrischen Schaltgeräts. Für die Abschätzung eines Ausfallrisikos des elektrischen Schaltgeräts kann damit der Frage nachgegangen werden, ob eine Abweichung des festgestellten Ist-Werts der Temperatur vom Soll-Wert der Temperatur toleriert werden kann oder ob mit einem Ausfall des elektrischen Schaltgeräts gerechnet werden muss, so dass Maßnahmen notwendig sind, um den Ausfall des elektrischen Schaltgeräts zu vermeiden.

Um das Ausfall-Risiko für das elektrischen Schaltgerät abschätzen zu können, wird, die Temperatur des elektrischen Schaltgeräts überwacht. Durch die Temperaturabhängigkeit des dielektrischen Parameters kann auf die Ist-Temperatur des Kapazitäts-Dielektrikums und damit auf die Ist-Temperatur des elektrischen Schaltgeräts geschlossen werden.

Zur Lösung der Aufgabe wird auch ein Verfahren zum Detektieren eines Fehlers des elektrischen Schaltgeräts angegeben. Dabei wird als Fehler-Detektor ein Temperatur-Sensor zum Bestimmen einer Temperatur des elektrischen Schaltgeräts verwendet. Vorzugsweise werden dabei folgende Verfahrensschritte durchgeführt: a) Bereitstellen von Kapazitäts-Daten der Hochspannungs-Kapazität in Abhängigkeit von einer Temperatur des Kapazitäts-Dielektrikums, b) Bestimmen eines Ist-Werts der Kapazität der Hochspannungs-Kapazität mittels Messung einer an der Feld-Steuer-Elektrode anliegenden elektrischen Spannung und Bestimmen eines Ist-Werts einer elektrischen Referenz-Spannung des elektrischen Schaltgeräts und c) Ermitteln der Temperatur deselektrischen Schaltgeräts mit Hilfe einer Auswerte-Einheit unter Berücksichtigung der bereitgestellten Kapazitäts-Daten der Hochspannungs-Kapazität, des Ist-Werts der Kapazität der Hochspannungs-Kapazität und des Ist-Werts der elektrischen Referenz-Spannung des elektrischen Schaltgeräts. Insbesondere wird zum Bereitstellen der Kapazitäts-Daten eine bekannte Temperatur-Abhängigkeit mindestens eines dielektrischen Parameters der Hochspannungs-Kapazität verwendet. Das Berücksichtigen der Referenz-Spannung ist insofern vorteilhaft, als eine Spannungs-Änderung aufgrund der Änderung der Temperatur des elektrischen Schaltgeräts deutlich höher ausfallen kann als eine Änderung der Kapazität der Hochspannungs-Kapazität aufgrund derselben Änderung der Temperatur des Kapazitäts-Dielektrikums.

Als dielektrischer Parameter des Kapazitäts-Dielektrikums wird zumindest eine aus der Gruppe Verlustfaktor(tan δ) und relative Permittivität(ε_{R}) ausgewählte, temperaturabhängige Material-Größe des Kapazitäts-Dielektrikums verwendet. Vorteilhaft werden mehrere der Material-Größen verwendet, so dass die Genauigkeit der Bestimmung der Temperatur des Kapazitäts-Dielektrikums erhöht wird.

Vorteilhaft werden das Bestimmen des Ist-Werts der Kapazität der Hochspannungs-Kapazität und das Bestimmen des Ist-Werts der elektrischen Referenz-Spannung bei einer im Wesentlichen gleichen Temperatur durchgeführt. Die zulässige Abweichung hängt dabei von der Temperaturabhängigkeit der Referenz-Spannungsmessung ab. Bei Verwendung eines induktiven Spannungswandlers ist eine Abweichung innerhalb des gesamten Betriebsbereichs des Spannungswandlers im Allgemeinen möglich. Da die Messungen bei ungefähr der gleichen Temperatur durchgeführt werden, kann ein unterschiedlicher Einfluss der Temperatur auf die Messergebnisse für den Ist-Wert der Kapazität und den Ist-Wert der Referenz-Spannung vernachlässigt werden. Dafür werden beispielsweise die Kapazität und die Referenz-Spannung nach Einstellen eines thermischen Gleichgewichts zeitgleich bestimmt.

Vorteilhaft ist es zudem, das Bestimmen des Ist-Werts der Kapazität der Hochspannungs-Kapazität und das Bestimmen des Ist-Werts der elektrischen Referenz-Spannung bei einer im Wesentlichen gleichen Frequenz durchzuführen. Störende, frequenzabhängige Einflüsse auf die Messergebnisse können somit ebenfalls vernachlässigt werden.

Die Temperatur des elektrischen Schaltgeräts kann von vielen Faktoren abhängen. Insbesondere ist das Verfahren vorteilhaft, wenn die Temperatur des elektrischen Schaltgeräts im Wesentlichen von einer Temperatur einer Schraubverbindung mit einem Hochspannungs-Kabel abhängt. Eine hohe Temperatur des elektrischen Schaltgeräts deutet auf eine unsachgemäße Montage einer der hochspannungs-führenden Schraubverbindungen des elektrischen Schaltgeräts hin.

Im Hinblick auf das elektrische Schaltgerät ist es vorteilhaft, wenn das Kapazitäts-Dielektrikum mit Hilfe eines gießfähigen Dielektrikum-Ausgangs-Materials gebildet ist. Damit vereinfacht sich die Herstellung des elektrischen Schaltgeräts.

Als Dielektrika sind verschiedenste organische und/oder anorganische Kapazitäts-Materialien denkbar. Besonders vorteilhaft ist es, wenn das Kapazitäts-Dielektrikum mindestens ein aus der Gruppe Epoxid-Gießharz und Keramik ausgewähltes Kapazitäts-Material aufweist. Das hier eingesetzte Epoxid-Harz enthält i.d.R. mindestens einen anorganischen Füllstoff mit einem Anteil von z.B. 60 Gew.% und mehr. Der anorganische Füllstoff weist beispielsweise keramische und/oder glasartige Partikel auf.

Bezüglich des Verfahrens wird gemäß einer besonderen Ausgestaltung als Kapazitäts-Dielektrikum ein Epoxid-Harz verwendet, wobei das Bestimmen der Kapazität der Hochspannungs-Kapazität und das Bestimmen der Referenz-Spannung bei einer Glas-Übergangs-Temperatur des Epoxid-Harzes durchgeführt werden. Gerade bei der Glas-Übergangs-Temperatur verschlechtern sich die dielektrischen Eigenschaften des Epoxid-Gieß-Harzes deutlich. Damit kann die Temperatur des Kapazitäts-Dielektrikums und damit die Temperatur des elektrischen Schaltgeräts mit hoher Sicherheit bestimmt werden.

Im Hinblick auf das elektrische Schaltgeräts ist gemäß einer besonderen Ausgestaltung die Hochspannungs-Kapazität von einer Anschluss-Buchse des elektrischen Schaltgeräts gebildet.

Das Erfassen der Kapazität kann beliebig erfolgen. In einer besonderen Ausgestaltung ist das elektrische Schaltgerät dazu mit einer Schnittstelle zum Erfassen eines kapazitiven Ausgangs-Signals nach IEC61243-5/ 62271-213/ 62271-206 ausgestattet.

Gemäß einer weiteren Ausgestaltung des Verfahrens wird ein Vergleich mit einem Referenzwert in Form eines Signals einer benachbarten Phase und/oder einer gleichen Phase eines weiteren elektrischen Schaltgeräts für Hochspannung mit ausreichend ähnlicher Geometrie und ausreichen ähnlichen Materialeigenschaften durchgeführt. Damit kann eine relative Änderung ermittelt werden, beispielsweise dadurch, dass Grenzwerte vorgegeben werden, in welchem Rahmen diese relativen Änderungen zulässig sind.

Gemäß einem weiteren Aspekt der Erfindung wird das elektrische Schaltgerät für eine Schaltanlage zum Schalten eines elektrischen Stroms mit Hochspannung von über 1 kV verwendet.

Soll mit der Erfindung nur eine relative Änderung eines dielektrischen Parameters betrachtet werden, kann das Verfahren zusätzlich auch auf historische Daten angewendet werden, wenn z.B. noch weitere Parameter wie der Strom oder das zeitliche Verhalten des Stroms berücksichtigt werden oder ein Vergleich mit benachbarten Phasen, wenn die Spannung ausreichend symmetrisch ist, sowie mit benachbarten Schaltfeldern gleicher Phase. Dies kann insbesondere dadurch vorteilhaft sein, dass durch eine ausreichend große Anzahl an Schaltfeldern ausreichend viele Referenzwerte für eine erhöhte Genauigkeit vorhanden sind.

Da die für die Ermittlung der Temperatur des elektrischen Schaltgeräts über eine Rückrechnung aus einem ermittelten dielektrischen Parameter nur ein Durchschnittswert zugänglich ist, kann die Genauigkeit durch Gewichtung des Durchschnittswertes über weitere Parameter wie zeitliche Änderung des Stroms und Umgebungstemperatur in Kombination mit einem physikalischen Modell verbessert werden.

Zusammenfassend sind mit der Erfindung folgende Vorteile hervorzuheben:
- Aufgrund des in einem elektrischen Schaltgerät integrierten Fehler-Detektors ist kein Einsatz eines diskreten Bauteils notwendig. Es werden bestehende Bauteile des elektrischen Schaltgeräts verwendet.
- Zum Bereitstellen von Kapazitäts-Daten der Hochspannungs-Kapazität können bereits vorhandene Datenquellen verwendet werden. Somit sind keine Arbeiten im Hochspannungsbereich notwendig.
- Eine Feld-Steuer-Elektrode sitzt in manchen Anlagentypen des elektrischen Schaltgeräts näher an der Fehlerstelle als ein zu platzierender Fehler-Sensor.

Anhand eines Ausführungsbeispiels und der dazugehörigen Figuren wird die Erfindung im Folgenden näher beschrieben. Die Figuren sind schematisch und stellen keine maßstabsgetreuen Abbildungen dar.

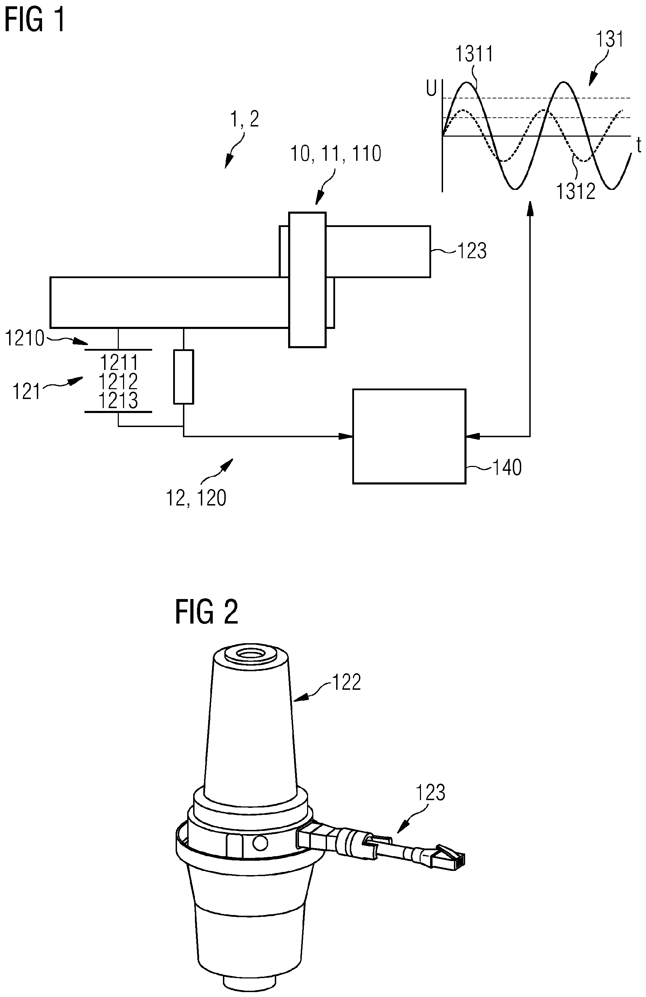

Figur 1 zeigt ein Schaubild für die Funktionsweise des elektrischen Schaltgeräts mit integriertem Fehler-Detektor.
Figur 2 zeigt eine Anschluss-Buchse eines HochspannungsKabels des elektrischen Schaltgeräts.
Figur 3 zeigt Messergebnisse der dielektrischen Parameter in Abhängigkeit von der Temperatur.
Figur 4 zeigt ein Verfahren zum Bestimmen der Temperatur einer Komponente des elektrischen Schaltgeräts.

Gegeben ist eine Schaltanlage 2 mit einem elektrischen Schaltgerät 1 für Hochspannung. Mit dem elektrischen Schaltgerät 1 kann ein elektrischer Strom mit Hochspannung (Wechselstrom-Spannung von über 1 kV) geschaltet werden. Das elektrische Schaltgerät 1 ist über eine Anschluss-Buchse 122 an ein Hochspannungs-Kabel 123 angeschlossen.

Das elektrische Schaltgerät 1 verfügt über eine Feld-Steuer-Elektrode 11 zur Feld-Steuerung mindestens einer hochspannungs-führenden Komponente 10 des elektrischen Schaltgeräts 1 und über einen integrierten Fehler-Detektor 12. Der integrierte Fehler-Detektor 12 ist ein Temperatur-Sensor 120. Die hochspannungsführende Komponente 10 des elektrischen Schaltgeräts 1 ist eine Schraubverbindung 110.

Für den Temperatur-Sensor 120 weisen die Feld-Steuer-Elektrode 11 eine Kapazitäts-Elektrode 1210 einer Hochspannungs-Kapazität 121 des elektrischen Schaltgeräts 1 und die hochspannungsführende Komponente 10 (Schraubverbindung 110) ein mit der Feld-Steuer-Elektrode 11 elektrisch gekoppeltes Kapazitäts-Dielektrikum 1211 auf.

Das Kapazitäts-Dielektrikum 1211 weist einen eine Temperaturabhängigkeit zeigenden dielektrischen Parameter 1212 auf. Das Kapazitäts-Dielektrikum 1211 ist ein mit Quarzmehl gefülltes Epoxid-Gießharz.

Zum Bestimmen der Temperatur der Komponente (Schraubverbindung) 10 des elektrischen Schaltgeräts 1 ist dafür gesorgt, dass sich die hochspannungsführende Komponente 10 und der Temperatur-Sensor 120 im thermischen Austausch befinden. Zwischen der Komponente und dem Temperatur-Sensor wird thermische Energie ausgetauscht.

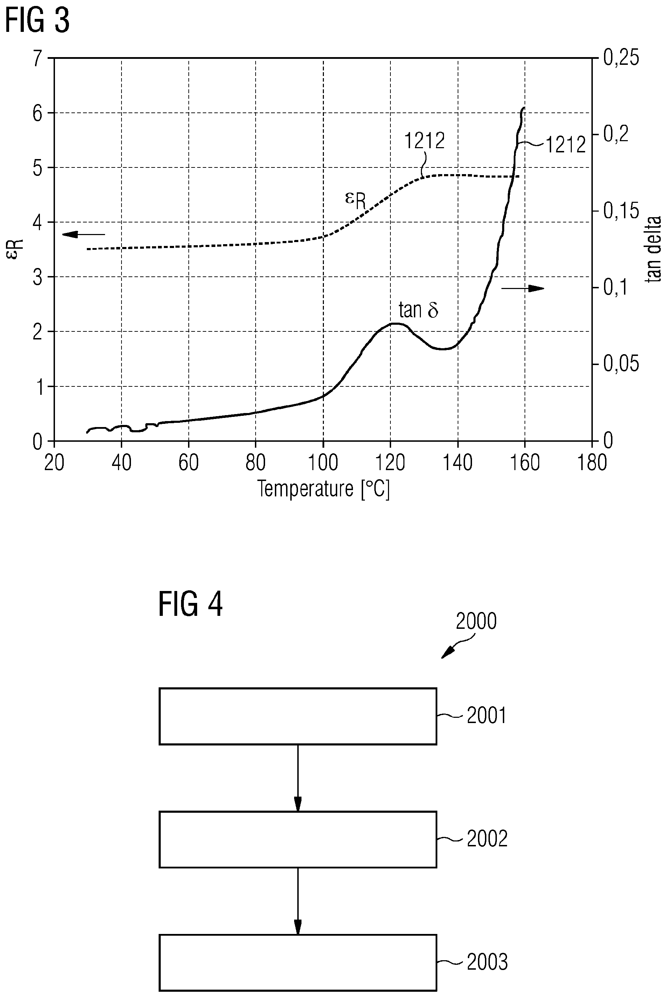

Zum Bestimmen der Temperatur der hochspannungs-führenden Komponente 10 werden folgende Verfahrensschritte durchgeführt (Figur 4):
a) Bereitstellen 2001 von Kapazitäts-Daten der Hochspannungs-Kapazität 121 in Abhängigkeit von einer Temperatur des Kapazitäts-Dielektrikums 1211,
b) Bestimmen 2002 eines Ist-Werts der Kapazität der Hochspannungs-Kapazität 121 mittels Messung einer an der Feld-Steuer-Elektrode 11 anliegenden elektrischen Spannung und Bestimmen eines Ist-Werts einer elektrischen Referenz-Spannung des elektrischen Schaltgeräts 1 und
c) Ermitteln 2003 der Temperatur des elektrischen Schaltgeräts 1 mit Hilfe einer Auswerte-Einheit 140 unter Berücksichtigung der bereitgestellten Kapazitäts-Daten der Hochspannungs-Kapazität 121, des Ist-Werts der Kapazität der Hochspannungs-Kapazität 121 und des Ist-Werts der elektrischen Referenz-Spannung 131 des elektrischen Schaltgeräts 1.

Zum Bereitstellen der Kapazitäts-Daten wir eine Temperatur-Abhängigkeit von dielektrischen Kapazitäts-Parameter 1212 des Kapazitäts-Dielektrikums 1211 verwendet. Als dielektrische Parameter werden der Verlustfaktor tan δ und die relative Permittivität ε_{R} des Epoxid-Gieß-Harzes betrachtet.

Das Bestimmen des Ist-Werts der Kapazität der Hochspannungs-Kapazität 121 und das Bestimmen des Ist-Werts der elektrischen Referenz-Spannung 131 wird bei einer im Wesentlichen gleichen Frequenz durchgeführt. Die Frequenz (Mess-Frequenz) beträgt dazu 50 Hz (1311) und in einer alternativen Ausführung 60 Hz (1312).

Verwendung findet das elektrische Schaltgerät 1 in einer Schaltanlage 2 zum Schalten eines elektrischen Stroms mit Hochspannung von über 1 kV.

## Patentansprüche

1. Elektrisches Schaltgerät (1) für Hochspannung mit
- mindestens einer Feld-Steuer-Elektrode (11) zur Feld-Steuerung mindestens einer hochspannungs-führenden Komponente (10) des elektrischen Schaltgeräts (1) und
- mit mindestens einen im elektrischen Schaltgerät (1) integrierten Fehler-Detektor (12) zum Detektieren eines Fehlers des elektrischen Schaltgeräts (1), wobei
- der Fehler-Detektor (12) die Feld-Steuer-Elektrode (11) aufweist,
- der Fehler-Detektor (12) einen Temperatur-Sensor (120) zum Erfassen einer Temperatur des elektrischen Schaltgeräts (1) aufweist und für den Temperatur-Sensor (120)
- die Feld-Steuer-Elektrode (11) mindestens eine Kapazitäts-Elektrode (1210) einer Hochspannungs-Kapazität (121) des elektrischen Schaltgeräts (1) aufweist,
- die Hochspannungs-Komponente (10) ein mit der Feld-Steuer-Elektrode (11) elektrisch gekoppeltes Kapazitäts-Dielektrikum (1211) aufweist und
- das Kapazitäts-Dielektrikum (1211) mindestens einen eine Temperaturabhängigkeit aufweisenden dielektrischen Parameter (1212) aufweist.

2. Elektrisches Schaltgerät (1) nach Anspruch 1, wobei das Kapazitäts-Dielektrikum (1211) mit Hilfe eines gießfähigen Dielektrikum-Ausgangs-Materials gebildet ist.

3. Elektrisches Schaltgerät (1) nach Anspruch 1 oder 2, wobei das Kapazitäts-Dielektrikum (1211) mindestens ein aus der Gruppe Epoxid-Gießharz und Keramik ausgewähltes Kapazitäts-Material (1213) aufweist.

4. Elektrisches Schaltgerät (1) nach einem der Ansprüche 1 bis 3, wobei die Hochspannungs-Kapazität (121) von einer Anschluss-Buchse (122) des elektrischen Schaltgeräts (1) gebildet ist.

5. Elektrisches Schaltgerät nach einem der Ansprüche 1 bis 4 mit einer Schnittstelle zum Erfassen eines kapazitiven Ausgangs-Signals nach IEC61243-5/ 62271-213/ 62271-206.

6. Verfahren zum Detektieren eines Fehlers eines elektrischen Schaltgeräts (1) nach einem der Ansprüche 1 bis 5, wobei als Fehler-Detektor (12) ein Temperatur-Sensor (120) zum Bestimmen einer Temperatur des elektrischen Schaltgeräts (1) verwendet wird.

7. Verfahren nach Anspruch 6, wobei zum Bestimmen der Temperatur des elektrischen Schaltgeräts (1) folgende Verfahrensschritte durchgeführt werden:
a) Bereitstellen (2001) von Kapazitäts-Daten der Hochspannungs-Kapazität (121) in Abhängigkeit von einer Temperatur des Kapazitäts-Dielektrikums (1211),
b) Bestimmen (2002) eines Ist-Werts der Kapazität der Hochspannungs-Kapazität (121) mittels Messung einer an der Feld-Steuer-Elektrode (11) anliegenden elektrischen Spannung und Bestimmen eines Ist-Werts einer elektrischen Referenz-Spannung des elektrischen Schaltgeräts (1) und
c) Ermitteln (2003) der Temperatur des elektrischen Schaltgeräts (1) mit Hilfe einer Auswerte-Einheit (140) unter Berücksichtigung der bereitgestellten Kapazitäts-Daten der Hochspannungs-Kapazität (121), des Ist-Werts der Kapazität der Hochspannungs-Kapazität (121) und des Ist-Werts der elektrischen Referenz-Spannung (131) des elektrischen Schaltgeräts (1).

8. Verfahren nach 7, wobei zum Bereitstellen der Kapazitäts-Daten eine bekannte Temperatur-Abhängigkeit mindestens eines dielektrischen Parameters (1212) der Hochspannungs-Kapazität (121) verwendet wird.

9. Verfahren nach Anspruch 8, wobei als dielektrischer Parameter (1212) des Kapazitäts-Dielektrikums (1211) zumindest eine aus der Gruppe Verlustfaktor und relative Permittivität ausgewählte, temperaturabhängige Material-Größe des Kapazitäts-Dielektrikums verwendet wird.

10. Verfahren nach einem der Ansprüche 7 bis 9, wobei das Bestimmen des Ist-Werts der Kapazität der Hochspannungs-Kapazität (121) und das Bestimmen des Ist-Werts der elektrischen Referenz-Spannung (131) bei einer im Wesentlichen gleichen Temperatur durchgeführt werden.

11. Verfahren nach einem der Ansprüche 7 bis 10, wobei das Bestimmen des Ist-Werts der Kapazität der Hochspannungs-Kapazität (121) und das Bestimmen des Ist-Werts der elektrischen Referenz-Spannung (131) bei einer im Wesentlichen gleichen Frequenz (1311, 1312) durchgeführt werden.

12. Verfahren nach einem der Ansprüche 7 bis 11, wobei die Temperatur des elektrischen Schaltgeräts (1) im Wesentlichen von einer Temperatur einer Schraubverbindung (110) mit einem Hochspannungs-Kabel (123) abhängt.

13. Verfahren nach einem der Ansprüche 7 bis 12, wobei als Kapazitäts-Dielektrikum (1211) ein Epoxid-Harz verwendet wird und das Bestimmen der Kapazität der Hochspannungs-Kapazität (121) und das Bestimmen der Referenz-Spannung (131) bei einer Glas-Übergangs-Temperatur des Epoxid-Harzes durchgeführt werden.

14. Verfahren nach einem der Ansprüche 7 bis 13, wobei ein Vergleich mit einem Referenzwert in Form eines Signals einer benachbarten Phase und/oder einer gleichen Phase eines weiteren elektrischen Schaltgeräts für Hochspannung mit ausreichend ähnlicher Geometrie und ausreichend ähnlichen Materialeigenschaften durchgeführt wird.

15. Verwendung eines elektrischen Schaltgeräts (1) nach einem der Ansprüche 1 bis 5 für eine Schaltanlage (2) zum Schalten eines elektrischen Wechsel-Stroms mit Hochspannung von über 1 kV.

## Claims

1. Electrical switching device (1) for high voltage, having
- at least one field control electrode (11) for controlling the field of at least one high-voltage-carrying component (10) of the electrical switching device (1) and
- having at least one fault detector (12) for detecting a fault in the electrical switching device (1), said fault detector being integrated in the electrical switching device (1), wherein
- the fault detector (12) comprises the field control electrode (11),
- the fault detector (12) comprises a temperature sensor (120) for measuring a temperature of the electrical switching device (1) and for the temperature sensor (120)
- the field control electrode (11) comprises at least one capacitance electrode (1210) of a high-voltage capacitor (121) of the electrical switching device (1),
- the high-voltage component (10) comprises a capacitance dielectric (1211) which is electrically coupled to the field control electrode (11) and
- the capacitance dielectric (1211) has at least one dielectric parameter (1212) having a temperature dependency.

2. Electrical switching device (1) according to Claim 1, wherein the capacitance dielectric (1211) is formed with the aid of a castable dielectric starting material.

3. Electrical switching device (1) according to Claim 1 or 2, wherein the capacitance dielectric (1211) comprises at least one capacitance material (1213) selected from the group of epoxy casting resin and ceramic.

4. Electrical switching device (1) according to one of Claims 1 to 3, wherein the high-voltage capacitor (121) is formed of a connection socket (122) of the electrical switching device (1).

5. Electrical switching device according to one of Claims 1 to 4 having an interface for sensing a capacitive output signal in accordance with IEC61243-5/ 62271-213/ 62271-206.

6. Method for detecting a fault in an electrical switching device (1) according to one of Claims 1 to 5, wherein, as fault detector (12), a temperature sensor (120) is used to determine a temperature of the electrical switching device (1).

7. Method according to Claim 6, wherein, in order to determine the temperature of the electrical switching device (1), the following method steps are carried out:
a) providing (2001) capacitance data of the high-voltage capacitor (121) on the basis of a temperature of the capacitance dielectric (1211),
b) determining (2002) an actual value of the capacitance of the high-voltage capacitor (121) by measuring an electrical voltage present at the field control electrode (11) and determining an actual value of an electrical reference voltage of the electrical switching device (1) and
c) ascertaining (2003) the temperature of the electrical switching device (1) with the aid of an evaluation unit (140) taking into account the provided capacitance data of the high-voltage capacitor (121), the actual value of the capacitance of the high-voltage capacitor (121) and the actual value of the electrical reference voltage (131) of the electrical switching device (1).

8. Method according to Claim 7, wherein, in order to provide the capacitance data, a known temperature dependency of at least one dielectric parameter (1212) of the high-voltage capacitor (121) is used.

9. Method according to Claim 8, wherein at least one temperature-dependent material variable of the capacitance dielectric selected from the group of loss factor and relative permittivity is used as the dielectric parameter (1212) of the capacitance dielectric (1211).

10. Method according to one of Claims 7 to 9, wherein the actual value of the capacitance of the high-voltage capacitor (121) and the actual value of the electrical reference voltage (131) are determined at an essentially identical temperature.

11. Method according to one of Claims 7 to 10, wherein the actual value of the capacitance of the high-voltage capacitor (121) and the actual value of the electrical reference voltage (131) are determined at an essentially identical frequency (1311, 1312).

12. Method according to one of Claims 7 to 11, wherein the temperature of the electrical switching device (1) depends essentially on a temperature of a screw connection (110) to a high-voltage cable (123).

13. Method according to one of Claims 7 to 12, wherein an epoxy resin is used as the capacitance dielectric (1211) and the capacitance of the high-voltage capacitor (121) and the reference voltage (131) are determined at a glass transition temperature of the epoxy resin.

14. Method according to one of Claims 7 to 13, wherein a comparison with a reference value in the form of a signal of an adjacent phase and/or an identical phase of a further electrical switching device for high voltage having a sufficiently similar geometry and sufficiently similar material properties is carried out.

15. Use of an electrical switching device (1) according to one of Claims 1 to 5 for a switching installation (2) for switching an electrical AC current with high voltage of over 1 kV.

## Revendications

1. Appareil de commutation électrique (1) haute tension avec
- au moins une électrode de commande de champ (11) pour la commande de champ d'au moins un composant haute tension (10) de l'appareil de commutation électrique (1) et
- avec au moins un détecteur de défaut (12) intégré dans l'appareil de commutation électrique (1) pour la détection d'un défaut de l'appareil de commutation électrique (1), dans lequel
- le détecteur de défaut (12) présente l'électrode de commande de champ (11),
- le détecteur de défaut (12) présente un capteur de température (120) pour la détection d'une température de l'appareil de commutation électrique (1) et, pour le capteur de température (120)
- l'électrode de commande de champ (11) présente au moins une électrode capacitive (1210) d'une capacité haute tension (121) de l'appareil de commutation électrique (1),
- le composant haute tension (10) présente un diélectrique capacitif (1211) couplé électriquement à l'électrode de commande de champ (11) et
- le diélectrique capacitif (1211) présente au moins un paramètre diélectrique (1212) dépendant de la température.

2. Appareil de commutation électrique (1) selon la revendication 1, dans lequel le diélectrique capacitif (1211) est composé d'un matériau de base diélectrique pouvant être moulé.

3. Appareil de commutation électrique (1) selon la revendication 1 ou 2, dans lequel le diélectrique capacitif (1211) présente au moins un matériau capacitif (1213) choisi dans le groupe comprenant la résine époxy et la céramique.

4. Appareil de commutation électrique (1) selon l'une des revendications 1 à 3, dans lequel la capacité haute tension (121) est formée par une prise de raccordement (122) de l'appareil de commutation électrique (1).

5. Appareil de commutation électrique selon l'une des revendications 1 à 4 avec une interface pour la détection d'un signal de sortie capacitif selon les normes CEI61243-5 / 62271-213 / 62271-206.

6. Procédé pour la détection d'un défaut d'un appareil de commutation électrique (1) selon l'une des revendications 1 à 5, dans lequel un capteur de température (120) est utilisé comme détecteur de défaut (12) pour la détermination d'une température de l'appareil de commutation électrique (1).

7. Procédé selon la revendication 6, dans lequel, pour la détermination de la température de l'appareil de commutation électrique (1), les étapes suivantes sont effectuées :
a) mise à disposition (2001) de données de capacité de la capacité haute tension (121) en fonction d'une température du diélectrique capacitif (1211),
b) définition (2002) d'une valeur réelle de capacité de la capacité haute tension (121) au moyen d'une mesure d'une tension électrique appliquée à l'électrode de commande de champ (11) et définition d'une valeur réelle d'une tension électrique de référence de l'appareil de commutation électrique (1) et
c) détermination (2003) de la température de l'appareil de commutation électrique (1) à l'aide d'une unité d'évaluation (140) en tenant compte des données de capacité de la capacité haute tension (121) mises à disposition, de la valeur réelle de capacité de la capacité haute tension (121) et de la valeur réelle de la tension électrique de référence (131) de l'appareil de commutation électrique (1).

8. Procédé selon la revendication 7 dans lequel une dépendance connue à la température d'au moins un paramètre diélectrique (1212) de la capacité haute tension (121) est utilisée pour la mise à disposition des données de capacité.

9. Procédé selon la revendication 8, dans lequel au moins une grandeur du matériau du diélectrique capacitif dépendante de la température, choisie dans le groupe comprenant le facteur de perte et la permittivité relative est utilisée en tant que paramètre diélectrique (1212) du diélectrique capacitif (1211).

10. Procédé selon l'une des revendications 7 à 9, dans lequel la détermination de la valeur réelle de capacité de la capacité haute tension (121) et la détermination de la valeur réelle de la tension électrique de référence (131) sont effectuées à une température sensiblement identique.

11. Procédé selon l'une des revendications 7 à 10, dans lequel la détermination de la valeur réelle de capacité de la capacité haute tension (121) et la détermination de la valeur réelle de la tension électrique de référence (131) sont effectuées à une fréquence (1311, 1312) sensiblement identique.

12. Procédé selon l'une des revendications 7 à 11, dans lequel la température de l'appareil de commutation électrique (1) dépend essentiellement de la température d'un raccord vissé (110) avec un câble haute tension (123).

13. Procédé selon l'une des revendications 7 à 12, dans lequel une résine époxy est utilisée comme diélectrique capacitif (1211) et la détermination de la capacité de la capacité haute tension (121) et la détermination de la tension de référence (131) sont effectuées à une température de transition vitreuse de la résine époxy.

14. Procédé selon l'une des revendications 7 à 13, dans lequel une comparaison est effectuée avec une valeur de référence sous la forme d'un signal provenant d'une phase voisine et/ou d'une phase identique d'un autre appareil de commutation électrique haute tension présentant une géométrie et des propriétés matérielles suffisamment similaires.

15. Utilisation d'un appareil de commutation électrique (1) selon l'une des revendications 1 à 5 pour un poste de commutation (2) pour la commutation d'un courant alternatif électrique à haute tension de plus de 1 kV.
